# EUROPEAN PATENT APPLICATION

(11) **EP 0 909 021 A2**
(43) Date of publication of application: **14.04.1999**
(21) Application number: 98113842.3
(22) Date of filing: 23.07.1998
(51) Int. Cl.: H03F 3/08

(54) **Transimpedance pre-amplifier for optical communication**

(30) Priority: 09.10.1997 JP 277255/97
(71) Applicant: Matsushita Electric Industrial Co., Ltd., Kadoma-shi, Osaka 571-8501 (JP)
(72) Inventor: Fujimoto, Kazuhisa, Souraku-gun, Kyoto 619-0237 (JP)
(74) Representative: Grünecker, Kinkeldey, Stockmair & Schwanhäusser Anwaltssozietät

(57) **Abstract**

A transimpedance pre-amplifier is disclosed. A first FET and a second FET are disposed. An optical input current, accepted at an input terminal of the transimpedance pre-amplifier, is delivered to the gate of the first FET. The drain of the first FET is connected to a power supply terminal via a second load resistor and the source thereof is connected to ground. The gate of the second FET is connected to a joint point common to the second load resistor and the first FET via a first inter-stage coupling capacitor, the drain thereof is connected to the power supply terminal, and the source thereof is connected to the gate of the first FET via a feedback resistor and a feedback coupling capacitor, whereby a negative feedback loop is formed. In addition to the first and second FETs, a third FET is disposed. The gate of the third FET is conceded to the source of the second FET via a second inter-stage coupling capacitor, the drain thereof is connected to the power supply terminal, and the source thereof is connected to an output terminal of the transimpedance pre-amplifier.

## Description

### BACKGROUND OF THE INVENTION

The present invention relates generally to transimpedance pre-amplifiers used in optical communication. The present invention pertains more specifically to a transimpedance pre-amplifier in which compound semiconductor field effect transistors (FET) act as amplifying components.

With the advance of information and communication, there have been strong demands for optical communication systems as communication means. The transmission rate has been improved significantly. For instance, in the field of IM-DD digital transmission system, transmission rate at 2.4- and 10-Gbps has been in service. Much faster transmission rate (over 20 Gbps) has been studied intently.

Much effort has been devoted for the realization of optical communication systems capable of analog transmission of frequency-multiplexed signals or the like. The narrow bandwidth transmission includes an optical communication system among base stations in the area of mobile communication making utilization of either an 800-MHz band, a 1.5-GHz band, or a 1.9-GHz band. On the other hand, the broad band transmission includes a transmission of 40ch tv signals (modulation method: VSB-AM) and 30ch digital video signals (modulation method: 64QAM) using a frequency range from 50 MHz to 800 MHz, for example.

Such optical communication systems require an optical transmitter which converts an electrical signal into an optical signal and an optical receiver which converts an optical signal received into an electrical signal correctly.

### FIRST CONVENTIONAL EXAMPLE

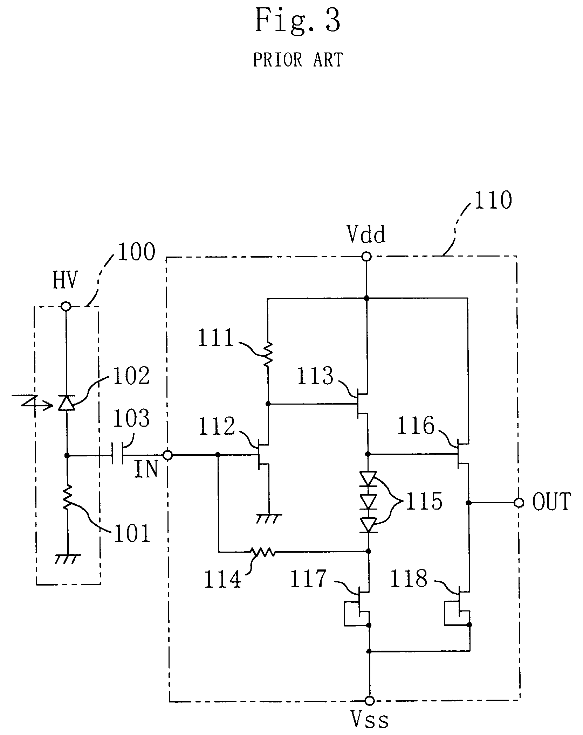

Referring to FIGURE **3**, a commonly used digital-transmission transimpedance pre-amplifier for use in optical receivers is described as a first prior art example.

FIGURE 3 is a circuit diagram of a conventional digital-transmission transimpedance pre-amplifier **110**. FIGURE **3** shows that the transimpedance pre-amplifier **110** is connected to an optical receiver **100**.

The optical receiver **100** has a photo diode **102** which converts an optical signal into an optical current. The photo diode **102** is an avalanche photodiode, a PIN photodiode or the like. The cathode of the photo diode **102** is connected to a high-voltage power supply terminal **HV** of a high voltage in the range from 20V to 30V. The anode of the photo diode **102** is connected to a first load resistor **101**. The photo diode **102** is connected so as to be reverse-biased with the other terminal of the first load resistor **101** connected to ground. A junction point common to the anode of the photo diode **102** and the first load resistor **101** is coupled, via a capacitor **103** for DC blocking, to an input terminal **IN** of the transimpedance pre-amplifier **110**.

The photo diode **102** converts an optical signal into optical current. The optical current is delivered to the input terminal **IN** of the transimpedance pre-amplifier **110**. In addition to the input terminal **IN**, the transimpedance pre-amplifier **110** includes a second load resistor **111**, a first FET **112**, a second FET **113**, a feedback resistor **114**, a group of level shift diodes **115**, a third FET **116**, a first current supply FET **117**, a second current supply FET **118**, an output terminal **OUT**, a positive power supply terminal **Vdd**, and a negative power supply terminal **Vss**. The FET **112** receives an optical current at its gate. The drain of the FET **112** is connected, via the load resistor **111**, to the **Vdd** terminal coupled to + 9V and the source thereof is connected to ground. The gate of the FET **113** is connected to a joint point common to the load resistor **111** and the FET **112** and the drain thereof is connected to the **Vdd** terminal. The anode of the level shift diode group **115** is connected to the source of the FET **113** and the cathode thereof is coupled, via the feedback resistor **114**, to the gate of the FET **112**, whereby a negative feedback loop is formed. The gate of the FET **116** is connected to a joint point common to the source of the FET **113** and the anode of the level shift diode group **115**, the drain thereof is connected to the **Vdd** terminal, and the source thereof is connected to the output terminal **OUT**. The drain of the FET **117** is connected to the cathode of the level shift diode group **115** and the gate and the source thereof are connected to the **Vss** terminal coupled to - 3.5V. The drain of the FET **118** is connected to the source of the FET **116** and the gate and the source thereof are connected to the **Vss** terminal.

With a change in output impedance to about 50-75 Ω, an output signal from the output terminal **OUT** is fed into a post-amplifier (the main amplifier).

In accordance with the above-described transimpedance pre-amplifier **110**, the photo diode **102** converts an optical signal into an optical current. The optical current is amplified up to a designed level by means of a negative feedback amplifier comprising FETs disposed in a multiple-stage fashion. A GHz-bandwidth transimpedance pre-amplifier has been put into practical use in the form of a monolithic microwave integrated circuit (MMIC) formed in a single semiconductor substrate of GaAs or the like.

### SECOND CONVENTIONAL EXAMPLE

Like the above-described type of transimpedance pre-amplifier, commonly used MMICs employ a capacitor formed on a semiconductor substrate. Such a capacitor is a MIM (metal-insulator-metal) capacitor in which either a silicon dioxide (SiO₂) film or a silicon nitride (SiN) film is deposited as an insulator film by a chemical vapor deposition (CVD) method.

One disadvantage of the above-described conventional transimpedance pre-amplifier (i.e., the first conventional example) is discussed. In a conventional transimpedance pre-amplifier, FETs that form a transimpedance pre-amplifier are DC-connected. This requires the provision of a plurality of level shift diodes for setting respective DC biases to the FETs, a positive supply voltage (**Vdd**), and a negative supply voltage (**Vss**), the reason for which is that it is necessary to achieve an increased difference in potential between the supply voltages in the entire amplifier to secure an operating voltage for each one of the DC-connected FETs. With respect to the level shift diodes, it is required to perform a setting of parameters in such a way as to optimize the DC bias of the FETs of the pre-amplifier. Further, the provision of the level shift diodes is a bar to a reduction in size when trying to implement a transimpedance pre-amplifier by means of MMIC architecture.

The dual power supply structure requires a dedicated circuit for generating **Vss**. The voltage necessary for the operation of FETs is from about 2 volts to about 4 volts. Such a voltage is one normally applied between the drain and the source. However, the potential difference between **Vdd** and **Vss** is 12.5V, therefore producing the problem that low-power optical receivers cannot be achieved.

One disadvantage of the foregoing MMIC (i.e., the second conventional example) is discussed. Taking into account available areas on a MMIC, the capacitance of a MIM capacitor which employs as an insulator film either a SiO₂ film or a SiN film is limited to a capacitance in the range up to 50 pF. If a capacitor with such a capacitance value is used as a coupling capacitor, then the bandwidth on the low-frequency side is limited. This is a bar to the provision of broader bandwidths.

### SUMMARY OF THE INVENTION

Accordingly, a first object of the present invention is to provide solutions to the above-described problems with the prior art techniques as well as to realize a transimpedance pre-amplifier for optical communication simple in structure and low in power consumption. A second object of the present invention is to provide a transimpedance pre-amplifier for optical communication of higher density and broader bandwidth.

In order to achieve the first object, the present invention provides a novel transimpedance pre-amplifier for optical communication. More specifically, the transimpedance pre-amplifier of the present invention is connected to an output terminal of a photo diode for converting an optical signal into an electrical signal and comprises a first transistor which amplifies an input signal, a second transistor with a gate connected to a drain of the first transistor, a feedback resistor for returning a part of an output signal from a source of the second transistor to a gate of the first transistor, a first coupling capacitor so connected between the first transistor drain and the second transistor gate that direct currents between the first and second transistors are blocked, and a second coupling capacitor so connected between the second transistor source and the first transistor gate that direct currents between the first and second transistors are blocked.

An aspect of the above-described transimpedance pre-amplifier of the present invention is described. The transimpedance pre-amplifier of the present invention includes the first coupling capacitor and the second coupling capacitor. The first coupling capacitor is a DC blocking capacitor and is connected between the output terminal (drain) of the first transistor and the input terminal (gate) of the second transistor to block direct currents between the first transistor and the second transistor. The second coupling capacitor is a DC blocking capacitor and is connected between the output terminal (source) of the second transistor (the feedback loop output side in the second transistor) and the input terminal (gate) of the first transistor (the feedback loop input side in the first transistor) to block direct currents between the first transistor and the second transistor. In other words, the transistors are AC-connected, so that the FET operating voltage is a minimum bias voltage. This eliminates not only the necessity of providing level shift diodes used to optimize the DC bias of a plurality of transistors by means of a dual power supply structure but also the necessity of providing a negative power supply source to the level shift diodes. This provides a transimpedance pre-amplifier for optical communication simple in structure and small in size. Low voltage drive can be achieved, thereby providing a low-power transimpedance pre-amplifier for optical communication.

In order to achieve the second object, the present invention provides a first variation to the above-described transimpedance pre-amplifier. In accordance with the first variation, the first transistor, the second transistor, the feedback resistor, the first coupling capacitor, and the second coupling capacitor are all formed on the same semiconductor substrate. Further, the first and second coupling capacitors each have an insulator film formed of a dielectric having a high dielectric constant.

An aspect of the first variation is described. The first and second coupling capacitors each include an insulator film having a high dielectric constant, therefore having a higher capacitance in comparison with commonly-used coupling capacitors formed of a SiO₂ film or the like. The capacitance of a coupling capacitor formed in accordance with the first variation is greater than that of a conventional coupling capacitor if they occupy the same area. One advantage of the first variation is that even when a coupling capacitor formed in accordance with the first variation is used as an inter-stage coupling capacitor, a broad bandwidth MMIC can be realized. In respect of the area saving, the coupling capacitor of the first variation compares favorably with a conventional coupling capacitor if they have approximately the same capacitance. In other words, the present coupling capacitor requires a smaller formation area in comparison with the conventional coupling capacitor. A further reduction in dimensions can be achieved accordingly.

A second variation to the present invention can be made. In the second variation, the insulator film is formed of a dielectric having a high dielectric constant that contains therein an oxide of Ta (tantalum) or Ti (titanium).

An aspect of the second variation is that since dielectrics having a high dielectric constant have high adaptability for the semiconductor fabrication process, a desirable dielectric having a high dielectric constant can be obtained without increasing the number of semiconductor fabrication steps.

A third variation to the present invention can be made. In the third variation, the foregoing oxide is either a tantalum oxide (TaOₓ) or a strontium titanate oxide (SrTiOₓ) where the number x represents any positive integer.

### BRIEF DESCRIPTION OF THE DRAWINGS

FIGURE **1** is a circuit diagram of a transimpedance pre-amplifier for communication formed in accordance with a first embodiment of the present invention.
FIGURE **2** cross-sectionally partially shows the structure of a MMIC-architecture transimpedance pre-amplifier for optical communication in accordance with a second embodiment of the present invention.
FIGURE **3** is a circuit diagram of a conventional transimpedance pre-amplifier.

### DETAILED DESCRIPTION OF THE INVENTION

### FIRST EMBODIMENT

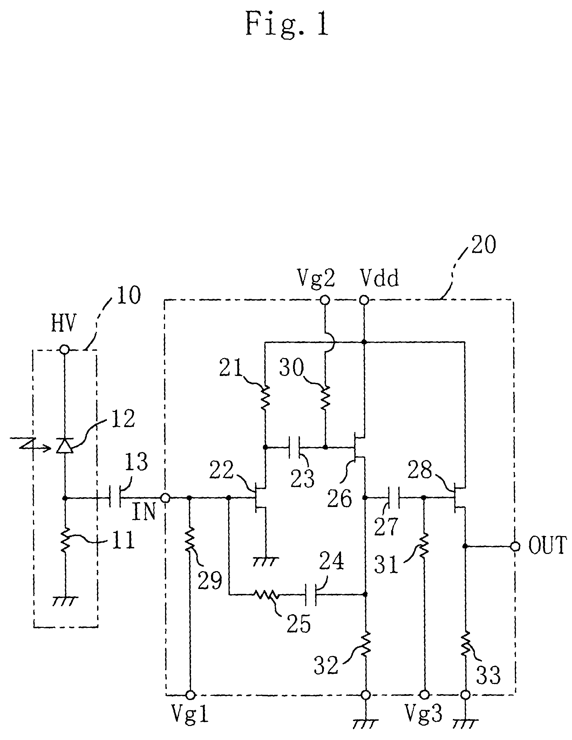

Referring to FIGURE **1**, a first embodiment of the present invention is described.

FIGURE **1** illustrates a transimpedance pre-amplifier for optical communication fabricated in accordance with the first embodiment of the present invention. **20** is a transimpedance pre-amplifier for optical communication of the first embodiment. As shown in FIGURE **1**, the transimpedance pre-amplifier **20** is connected to an optical receiver **10** which converts an optical input signal received from outside into an optical current.

The optical receiver **10** has a photo diode **12** which converts an optical input signal into an optical current. The photo diode **12** is an avalanche photodiode, a PIN photodiode or the like. The cathode of the photo diode **12** is connected to a high-voltage power supply terminal **HV** placed at a high voltage level in the range from 20 volts to 30 volts. The anode of the photo diode **12** is connected to one terminal of a first load resistor **11**. The photo diode **12** is connected so as to be reverse-biased with the other terminal of the first load resistor **11** connected to ground. A junction point common to the anode of the photo diode **12** and the first load resistor **11** is coupled, via a capacitor **13** which blocks direct currents, to an input terminal **IN** of the transimpedance pre-amplifier **20** at a high impedance.

The transimpedance pre-amplifier **20** has the input terminal **IN** at which to receive an optical current converted by the photo diode **12** from an optical external signal. In addition to the input terminal **IN**, the transimpedance pre-amplifier **20** further has a second load resistor **21**, a first FET **22**, a first inter-stage coupling capacitor **23**, a feedback coupling capacitor **24**, a feedback resistor **25**, a second FET **26**, a second inter-stage coupling capacitor **27**, a third FET **28**, a first gate bias resistor **29**, a second gate bias resistor **30**, a third gate bias resistor **31**, a first resistor **32**, a second resistor **33**, a + 3V power supply terminal **Vdd**, a first gate bias terminal **Vg1**, a second gate bias terminal **Vg2**, and a third gate bias terminal **Vg3**. The gate of the FET **22** is fed an optical input current via the input terminal **IN**. The drain of the FET **22** is connected, via the second load resistor **21**, to the **Vdd** terminal and the source thereof is connected to ground. The gate of the FET **26** is connected to a joint point common to the load resistor **21** and the FET **22** via the capacitor **23** (the first coupling capacitor), the drain thereof is connected to the **Vdd** terminal, and the source thereof is connected to the gate of FET **22** via the capacitor **24** (the second coupling capacitor) and the feedback resistor **25**, whereby a negative feedback loop is formed. The gate of the FET **28** is connected to the source of the FET **26** via the capacitor **27**, the drain thereof is connected to the **Vdd** terminal, and the source thereof is connected to the output terminal **OUT**. With a change in output impedance to about 50-75 Ω, a voltage signal output from the output terminal **OUT** is fed into a post-amplifier, i.e., a main amplifier, not shown in the figure.

In addition to the above-described connection relationship, the gate of the FET **22** is connected to the **Vg1** terminal via the resistor **29**. The gate of the FET **26** is connected to the **Vg2** terminal via the resistor **30**. The gate of the FET **28** is connected to the **Vg3** terminal via the resistor **31**.

The source of the FET **26** is connected to ground via the resistor **32**. The source of the FET **28** is connected to ground via the resistor **33**. The level of voltage that is applied to each gate bias terminal (**Vg1-Vg3**) depends on the FET size as well as on the FET threshold voltage for the case of GaAs FETs. Usually, the terminal voltage of these gate bias terminals is about - 1 volt.

In cases where the transimpedance pre-amplifier of the present embodiment is applied to analog transmission of a frequency range from 0.5 GHz to 6 GHz, it is sufficient that the capacitance of the capacitor **23** is about 30 pF and the capacitance of the capacitors **24** and **27** is about 150 pF.

In accordance with the present embodiment, the capacitors (**23**, **24**, **27**) establish inter-FET and in-feedback loop AC connections with respect to the FETs (**22**, **26**, **28**), thereby providing complement inter-FET and in-feedback loop DC blocking. This eliminates not only the necessity of holding the difference in potential between the power supply voltages above 10 volts but also the necessity of the provision of **Vss** and level shift diodes for FET DC bias setting. It is accordingly sufficient to provide to each amplifying FET a minimum operating voltage (for example, about 3 volts), thereby making it possible to drive a transimpedance pre-amplifier with a low voltage. A reduction in power consumption proportional to such a supply voltage reduction can be achieved. This provides practical advantages.

The present embodiment has been described in terms of transimpedance pre-amplifiers of 0.5- to 6-GHz analog transmission. It is to be noted that the present invention is not limited to such a transimpedance pre-amplifier.

### SECOND EMBODIMENT

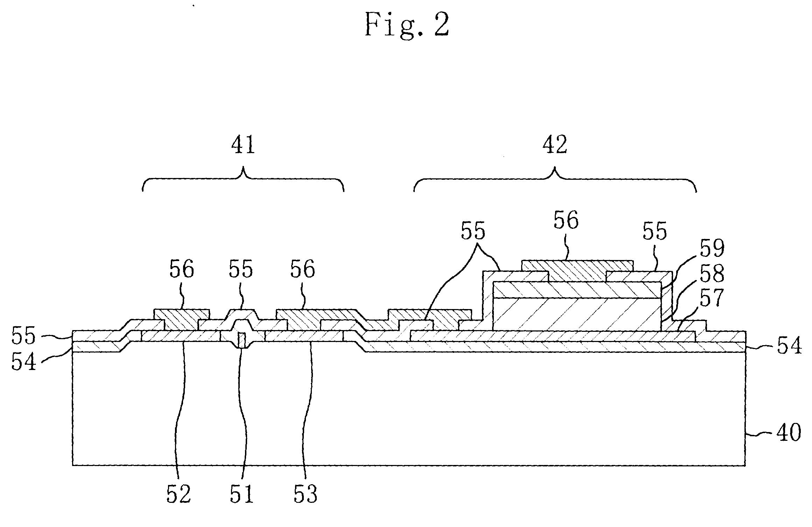

Referring to FIGURE **2**, a second embodiment of the present invention is now illustrated below.

FIGURE **2** cross-sectionally partially depicts the structure of a MMIC-architecture transimpedance pre-amplifier for optical communication in accordance with a second embodiment of the present invention. FIGURE **2** shows that an inter-stage coupling capacitor **42** is formed on a semiinsulate GaAs substrate **40**. The coupling capacitor **42** blocks direct currents between two FETs, for example between a FET **41** and another FET (not shown in the figure).

The FET **41** comprises a Schottky gate electrode **51** formed in a recess region, a source electrode **52**, and a drain electrode **53**. The source and drain electrodes **52** and **53** are formed at opposite sides with respect to the gate electrode **51**. The electrodes **51-53** are all covered with a first SiO₂ insulator film **54** and a second SiO₂ insulator film **55** so that the electrodes **51-53** are insulated from one another. **56** is a metal of aluminum or the like. Contact holes are formed through the insulator film **55**. The metal **56** is formed on top of each electrode **52** and **53** and filled in the contact holes for establishing electrical connection with the electrodes **52** and **53**.

The inter-stage coupling capacitor **42** comprises the following elements formed sequentially on the insulator film **54** on the semiinsulative substrate **40**, namely a lower electrode **57** of TiPt, an insulator film **58** of SrTiO₃ having a high dielectric constant, and an upper electrode **59** of WSiN/TiAu. The insulator film **58** is deposited using a low-temperature sputtering process. The insulator film **55** is deposited so as to cover the insulator film **58** and the upper electrode **59** on the upper surface of the lower electrode **57**. The metal **56** is formed at a peripheral area of the insulator film **58** in the upper surface of the lower electrode **57** and is filled within a contact hole formed in the insulator film **55** for establishing electrical connection with the lower electrode **57**. The metal **56** is formed on top of the upper electrode **59** and is filled in a contact hole formed in the insulator film **55** for establishing electrical connection with the upper electrode **59**.

For permitting the realization of a transimpedance pre-amplifier by means of MMIC architecture, such arrangements are made in the present embodiment that the inter-stage coupling capacitor **42** is disposed to block direct currents between the FET **41** and another FET and a film having a high dielectric constant of SrTiO₃ is used as an insulator film of the inter-stage coupling capacitor **42**.

SrTiO₃ has been studied and investigated intently with a view to applying it to DRAM capacitors because of its high relative dielectric constant. The dielectric constant of SrTiO₃ (which however depends on preparation conditions) ranges from about 100 to about 300. In respect of the relative dielectric constant, SrTiO₃ is about 20-50 times greater than materials commonly used in the semiconductor fabrication such as SiO₂ whose relative dielectric constant is 4.2 and SiN whose relative dielectric constant is 7.

SrTiO₃ is used to form an insulator film in the present embodiment. In respect of the area saving, a capacitor with a SrTiO₃ insulator film of the present embodiment compares favorably with a conventional capacitor that uses a SiO₂ or SiN insulator film. The present capacitor provides area saving so that the capacitor formation area is reduced to about 1/20 to 1/50 of the area of a conventional capacitor. This not only provides very large scale integration but also achieves a reduction in substrate dimensions.

If a capacitor that uses a SrTiO₃ insulator film and a conventional capacitor occupy the same area, then the former has a capacitance from about 20 times to about 50 times that of the conventional capacitor. This provides a low-power MMIC with broad bandwidth frequency characteristics. Such a transimpedance pre-amplifier cannot be provided by prior art techniques.

In the present embodiment, SrTiO₃ is used as a dielectric having a high dielectric constant. Instead of using SrTiO₃, TaOₓ can be employed.

It is to be noted that the capacitance of coupling capacitors that are connected between FETs or inserted within a feedback loop is chosen in a range in which a transimpedance pre-amplifier can be integrated to a MMIC according to the type and frequency bandwidth of transmission signal.

The description has been made in terms of transimpedance pre-amplifiers for optical communication as MMIC examples. If a dielectric having a high dielectric constant is used in forming various capacitors formed on MMICs, this not only provides very large scale integration but also achieves a reduction in substrate dimensions.

## Claims

1. A transimpedance pre-amplifier for optical communication,
said pre-amplifier being connected to an output terminal of a photo diode which converts an optical input signal into an electrical output signal;
said pre-amplifier comprising:
(a) a first transistor for amplifying and delivering an input signal;
(b) a second transistor with a gate connected to a drain of said first transistor;
(c) a feedback resistor for returning a part of an output signal from a source of said second transistor to a gate of said first transistor;
(d) a first coupling capacitor so connected between said first transistor drain and said second transistor gate that direct currents between said first transistor and said second transistor are blocked; and
(e) a second coupling capacitor so connected between said second transistor source and said first transistor gate that direct currents between said first transistor and said second transistor are blocked.

2. The transimpedance pre-amplifier for optical communication of claim 1,
wherein:
said first transistor, said second transistor, said feedback resistor, said first coupling capacitor, and said second coupling capacitor are all formed on a single semiconductor substrate; and
said first and second coupling capacitors each have an insulator film formed of a dielectric having a high dielectric constant.

3. The transimpedance pre-amplifier for optical communication of claim 2, wherein said insulator film is formed of a dielectric having a high dielectric constant that contains therein an oxide of Ta or Ti.

4. The transimpedance pre-amplifier of claim 3, wherein said oxide is either TaOₓ or SrTiOₓ.
